# DEMANDE DE BREVET EUROPEEN

(11) **EP 1 052 878 A1**
(43) Date de publication de la demande: **15.11.2000**
(21) Numéro de dépôt: 00401270.4
(22) Date de dépôt: 09.05.2000
(51) Int. Cl.: H04R 5/04, H03F 3/45, H03F 3/68

(54) **Dispositif de raccordement d'une source à un équipement de diffusion audiophonique notamment d'un véhicule automobile**

(30) Priorité: 10.05.1999 FR 9905933
(71) Demandeur: Peugeot Citroen Automobiles SA, 92200 Neuilly sur Seine (FR)
(72) Inventeur: Fromion, Alexandre, 92160 Antony (FR)
(74) Mandataire: Habasque, Etienne Joel Jean-François

(57) **Abrégé**

Ce dispositif de raccordement d'une source audiophonique (1) délivrant des signaux stéréophoniques, à un équipement de diffusion audiophonique (2) notamment d'un véhicule automobile, est caractérisé en ce qu'il comporte un étage d'entrée (3) comportant des moyens de mise en forme de signaux, recevant en entrée les signaux stéréophoniques (CDR,CDL) et la masse (CDGND) de la source audiophonique (1) et une tension de référence (Vref), pour délivrer des signaux de source référencés par rapport à la tension de référence, une liaison trifilaire torsadée (4) de transmission de ces signaux de source, et un étage de sortie (5) comportant des moyens d'adaptation d'impédance et d'amplification, pour récupérer les signaux stéréophoniques (CDR, CDL) sur la liaison trifilaire (4) et les délivrer à l'équipement de diffusion (2).

## Description

La présente invention concerne un dispositif de raccordement d'une source audiophonique délivrant des signaux stéréophoniques, à un équipement de diffusion audiophonique notamment d'un véhicule automobile.

L'intégration d'un nombre de plus en plus important de sources audiophoniques dans les véhicules automobiles, rend leur implantation et leur raccordement de plus en plus difficile.

En effet, toutes ces sources doivent être dispersées dans le véhicule en raison de contraintes d'encombrement, de déclinaison et de dissipation thermique.

Des liaisons filaires doivent alors être utilisées pour assurer le raccordement de ces sources aux équipements de diffusion embarqués à bord du véhicule.

Ces sources embarquées à bord d'un véhicule comprennent par exemple un autoradio, un lecteur de cassettes, un lecteur de disques compacts, un chargeur de disques, etc..., tandis que l'équipement de diffusion peut comporter par exemple un amplificateur associé à des haut-parleurs répartis dans l'habitacle du véhicule.

On conçoit alors que la qualité de la liaison de raccordement de ces sources à cet équipement de diffusion, est un point très important de la chaîne audiophonique.

En effet, ces liaisons doivent assurer la transmission des signaux audiophoniques, de façon fiable et sans en dégrader la qualité.

Or, les structures de liaison actuelles sont sujettes à des perturbations de différentes natures, comme par exemple des perturbations liées aux différences de potentiel de référence entre deux points du véhicule, des perturbations liées aux parasites des alimentations de ces différents moyens et des perturbations liées à des parasites qui viennent se coupler sur la liaison entre les sources et l'équipement de diffusion.

Pour tenter de résoudre certains de ces problèmes, on a déjà proposé d'utiliser des liaisons formées par des câbles blindés associés à des connecteurs blindés.

Cependant, de telles liaisons ne permettent pas de résoudre tous les problèmes évoqués précédemment et présentent un certain nombre d'inconvénients, notamment au niveau de leur coût.

Le but de l'invention est donc de résoudre ces problèmes.

A cet effet, l'invention a pour objet un dispositif de raccordement d'une source audiophonique délivrant des signaux stéréophoniques, à un équipement de diffusion audiophonique notamment d'un véhicule automobile, caractérisé en ce qu'il comporte :
- un étage d'entrée comportant des moyens de mise en forme de signaux, recevant en entrée les signaux stéréophoniques et la masse de la source audiophonique et une tension de référence, pour délivrer des signaux de source référencés par rapport à la tension de référence,
- une liaison trifilaire torsadée de transmission de ces signaux de source, et
- un étage de sortie comportant des moyens d'adaptation d'impédance et d'amplification, pour récupérer les signaux stéréophoniques sur la liaison trifilaire et les délivrer à l'équipement de diffusion.

L'invention sera mieux comprise à la lecture de la description qui va suivre, donnée uniquement à titre d'exemple et faite en se référant aux dessins annexés, sur lesquels :
- la Fig.1 représente un schéma synoptique d'un dispositif de raccordement selon l'invention; et
- la Fig.2 représente un circuit d'un exemple de réalisation d'un tel dispositif.

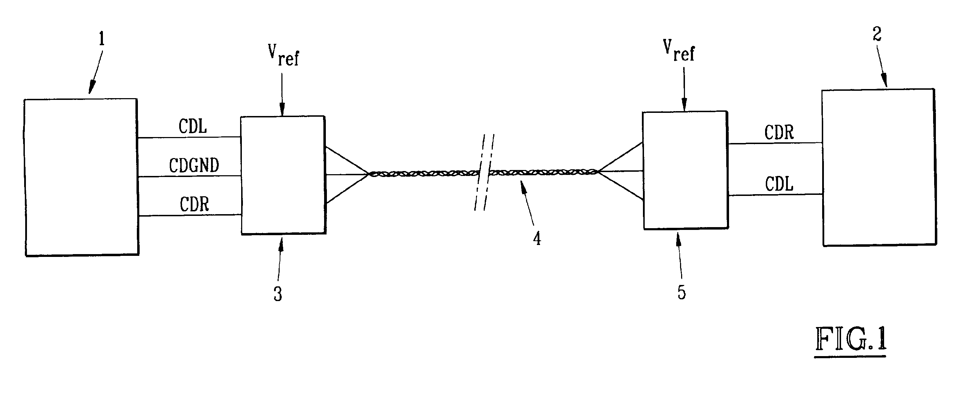

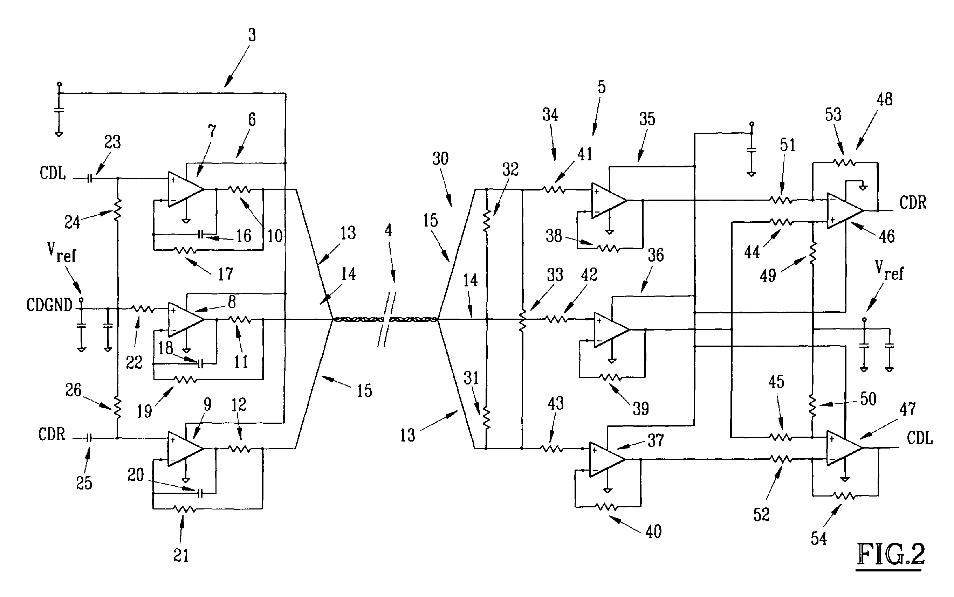

On a en effet représenté sur la figure 1, un schéma synoptique d'un dispositif de raccordement selon l'invention, qui permet de raccorder une source audiophonique désignée par la référence générale 1, à un équipement de diffusion audiophonique d'un véhicule automobile, cet équipement de diffusion étant désigné par la référence générale 2.

Il va de soi bien entendu que d'autres sources audiophoniques peuvent être connectées en parallèle de cette manière à l'équipement de diffusion.

La ou chaque source audiophonique 1 présente alors trois sorties, à savoir deux sorties de signaux stéréophoniques et une sortie de masse, qui sont appliquées à un étage d'entrée désigné par la référence générale 3 et qui sera décrit plus en détail par la suite.

Cet étage d'entrée 3 reçoit également une tension de référence Vref et comporte des moyens de mise en forme de ces signaux pour délivrer en sortie, à partir des signaux stéréophoniques et de la masse de la source, des signaux de source référencés par rapport à la tension de référence Vref.

Ces signaux de source sont alors appliqués à une liaison trifilaire torsadée désignée par la référence générale 4, qui s'étend entre cet étage d'entrée 3 et un étage de sortie désigné par la référence générale 5.

Cet étage de sortie 5 est associé à l'équipement de diffusion 2 et comporte des moyens d'adaptation d'impédance et d'amplification, qui seront décrits plus en détail par la suite, ces moyens permettant de récupérer sur la liaison trifilaire torsadée 4, les signaux stéréophoniques pour les délivrer à l'équipement afin qu'ils soient diffusés dans l'habitacle du véhicule.

Un exemple de réalisation de ces différents moyens est représenté sur la figure 2 où l'on reconnaît l'étage d'entrée 3, la liaison trifilaire torsadée 4 et l'étage de sortie 5.

Sur cette figure 2, les signaux stéréophoniques sont désignés par CDL et CDR, respectivement, et la masse de la source est désignée par CDGND.

Les moyens de mise en forme des signaux de l'étage d'entrée comportent alors un premier ensemble 6 de trois amplificateurs opérationnels, respectivement 7,8 et 9, associés aux signaux stéréophoniques CDL et CDR et à la masse CDGND de la source.

La sortie de chacun de ces amplificateurs opérationnels 7,8 et 9 est reliée à l'un des fils de la liaison trifilaire torsadée 4 à travers une résistance de sortie, respectivement 10,11 et 12, les trois fils de la liaison trifilaire torsadée 4 étant désignés par les références générales 13,14 et 15.

L'entrée inverseuse de chacun de ces amplificateurs opérationnels 7,8 et 9 est reliée d'une part, à sa sortie à travers un condensateur et d'autre part, au fil correspondant de la liaison trifilaire torsadée, à travers une résistance.

C'est ainsi que l'entrée inverseuse de l'amplificateur opérationnel 7 est reliée par un condensateur 16 et une résistance 17, d'une part, à sa sortie, c'est-à-dire à l'une des bornes de la résistance 10, et d'autre part, au fil 13 de la liaison trifilaire torsadée 4, c'est-à-dire en fait à l'autre borne de la résistance 10.

L'entrée inverseuse de l'amplificateur opérationnel 8 est reliée par un condensateur 18 à sa sortie et par une résistance 19, au fil 14 de la liaison trifilaire torsadée.

L'entrée inverseuse de l'amplificateur opérationnel 9 est reliée par un condensateur 20 à sa sortie et par une résistance 21, au fil 15 de la liaison trifilaire torsadée.

L'entrée non-inverseuse de l'amplificateur opérationnel 8 est reliée à la masse de la source CDGND et à la tension de référence Vref à travers une résistance d'entrée 22.

Des condensateurs en parallèle sont également prévus entre celle-ci et le zéro de la tension d'alimentation.

L'entrée non-inverseuse de l'amplificateur opérationnel 7 reçoit un signal stéréophonique par exemple CDL à travers un condensateur de découplage 23 et est reliée à la masse de la source CDGND et à la tension de référence Vref à travers une résistance 24.

L'entrée non-inverseuse de l'amplificateur opérationnel 9 reçoit l'autre signal stéréophonique, par exemple CDR, à travers un condensateur de découplage 25 et est reliée à la masse de la source CDGND et à la tension de référence Vref à travers une résistance 26.

Au niveau de l'étage de sortie 5, les moyens d'adaptation d'impédance et d'amplification comprennent un étage de charge 30, formé de trois résistances 31,32 et 33, raccordées en triangle entre les trois fils de la liaison torsadée 4.

C'est ainsi par exemple qu'une résistance 31 est raccordée entre les fils 13 et 14, qu'une résistance 32 est raccordée entre les fils 14 et 15 et qu'une résistance 33 est raccordée entre les fils 13 et 15.

Ces moyens d'adaptation d'impédance et d'amplification comprennent également un deuxième ensemble 34 de trois amplificateurs opérationnels désignés par les références générales 35,36 et 37 respectivement, dont l'entrée inverseuse de chacun est reliée à sa sortie à travers une résistance.

C'est ainsi par exemple que l'entrée inverseuse de l'amplificateur opérationnel 35 est reliée à sa sortie à travers une résistance 38, que l'entrée inverseuse de l'amplificateur opérationnel 36 est reliée à sa sortie à travers une résistance 39 et que l'entrée inverseuse de l'amplificateur opérationnel 37 est reliée à sa sortie à travers une résistance 40.

L'entrée non-inverseuse de chacun de ces amplificateurs opérationnels 35,36 et 37 est reliée à un fil respectif de la liaison trifilaire torsadée 4 à travers une résistance.

C'est ainsi par exemple que l'entrée non-inverseuse de l'amplificateur opérationnel 35 est reliée au fil 15 de la liaison 4 à travers une résistance 41, que l'entrée non-inverseuse de l'amplificateur opérationnel 36 est reliée au fil 14 de la liaison à travers une résistance 42 et que l'entrée non-inverseuse de l'amplificateur opérationnel 37 est reliée au fil 13 de la liaison à travers une résistance 43.

La sortie de l'amplificateur opérationnel 36 associée au fil de masse CDGND 14 de la liaison trifilaire 4 est reliée à travers des résistances respectivement 44 et 45, aux entrées non-inverseuses de deux amplificateurs opérationnels 46 et 47 d'un troisième ensemble 48 d'amplificateurs opérationnels.

Ces entrées non-inverseuses de ces amplificateurs opérationnels 46 et 47 sont également reliées à la tension de référence Vref à travers des résistances 49 et 50 respectivement.

Des condensateurs en parallèle sont également connectés entre cette tension de référence et le zéro de la tension d'alimentation.

Les entrées inverseuses de ces amplificateurs opérationnels 46 et 47 de ce troisième ensemble d'amplificateurs opérationnels, sont reliées aux sorties des amplificateurs opérationnels 35 et 37 respectivement, du deuxième ensemble d'amplificateurs opérationnels, à travers des résistances 51 et 52, respectivement.

Ces entrées inverseuses de ces amplificateurs opérationnels 46 et 47 sont également reliées à leur sortie à travers des résistances 53 et 54.

Ces sorties de ces amplificateurs opérationnels 46 et 47 délivrent les signaux stéréophoniques CDR et CDL respectivement, à l'équipement audiophonique.

Chaque signal de source CDL, CDR et CDGND est donc couplé à ce circuit pour être transmis de la façon la plus fiable possible à destination de l'équipement audiophonique.

Les signaux stéréophoniques CDL et CDR sont transmis à travers un condensateur, respectivement 23, 25, à l'entrée non-inverseuse d'un amplificateur opérationnel respectivement 7,9, monté en suiveur.

Une résistance 24,26 permet de polariser cette entrée de l'amplificateur opérationnel à une tension de référence Vref, par exemple de 5 volts, pour fixer le potentiel de repos de sortie de l'amplificateur opérationnel correspondant.

Le signal CDGND et cette tension de référence Vref sont transmis à l'entrée non-inverseuse de l'amplificateur opérationnel 8 à travers une résistance 22.

Les résistances 22,24 et 26 sont choisies égales aux résistances 17,19 et 21, de façon à compenser tout décalage dû au courant de polarisation de l'amplificateur opérationnel correspondant.

Les résistances 10,11 et 12 permettent de protéger les amplificateurs opérationnels par exemple en cas de mise accidentelle de la sortie de ceux-ci à la borne positive de la batterie d'alimentation en énergie du véhicule.

On notera que la contre-réaction de chaque amplificateur opérationnel est rejetée derrière cette résistance de sortie de chaque amplificateur opérationnel, ce qui permet de garantir une recopie exacte du signal d'entrée après cette résistance de sortie, la contre-réaction garantissant, pour la bande passante audiophonique, une impédance de sortie très proche de zéro.

Les condensateurs 16,18 et 20 permettent de compenser la charge capacitive que représente la liaison trifilaire torsadée, en évitant ainsi toute instabilité des amplificateurs opérationnels.

La bande passante du signal peut être optimisée en fonction du bruit, en réglant ces condensateurs.

Des structures symétriques sont donc utilisées pour les trois signaux de source CDL, CDR et CDGND.

La liaison trifilaire est torsadée avec un pas d'hélice constant de façon à garantir une symétrie maximale en termes de capacité et d'inductance mutuelle, de cette liaison vis-à-vis d'une perturbation.

Au niveau de l'étage de sortie, on trouve un étage de charge constitué de trois résistances identiques 31,32 et 33, branchées en triangle entre les fils de la liaison trifilaire, ce qui permet de garantir une symétrie parfaite des impédances vues par le reste de cet étage de sortie dans le cas où ces résistances ont de faible dispersion, par exemple de l'ordre de 0,1 ou 1%.

De plus, la structure de sortie des amplificateurs opérationnels de l'étage d'entrée limite la diaphonie entre les différentes voies.

Après passage dans cet étage de charge, les signaux passent dans trois amplificateurs opérationnels 35,36 et 37, montés en suiveur de façon à ne pas réduire la symétrie.

On notera que les résistances d'entrée de ceux-ci sont très élevées et que les résistances en série protègent ces amplificateurs opérationnels contre toute mise à la borne positive de la batterie d'alimentation du véhicule, de la liaison trifilaire.

Des résistances 38,39 et 40 insérées dans les boucles de réaction de ces amplificateurs opérationnels, permettent de limiter l'influence des courants de polarisation sur la précision de la tension de sortie.

Cet étage d'adaptation permet d'éviter la dégradation du taux de rejection de mode commun de l'étage différentiel, qui serait liée à la dissymétrie des impédances d'attaque.

En effet, ce taux de rejection est très sensible aux déséquilibres de l'impédance d'attaque.

L'impédance de sortie des amplificateurs montés en suiveur est très faible et ne dégrade donc pas le taux de rejection de mode commun.

Après cet étage d'adaptation est prévu un étage différentiel et d'amplification à fort taux de rejection de mode commun grâce à des résistances intégrées au circuit et ajustées lors de la conception du circuit.

Un condensateur de liaison permettant de débarrasser le signal de sortie de sa composante continue peut également être envisagé.

On conçoit alors que dans le dispositif selon l'invention, on utilise un circuit de rejection des tensions de mode commun et que le signal est transporté avec une référence de potentiel.

Au niveau de l'étage de sortie, un amplificateur différentiel soustrait les potentiels des deux voies pour extraire le signal utile référencé par rapport au potentiel de masse de l'équipement de diffusion.

Ce circuit de rejection est associé à une très bonne symétrie des fils de la liaison trifilaire, ce qui permet d'éviter l'utilisation de câbles et de connecteurs blindés évitant ainsi les coûts importants représentés par ceux-ci.

En effet, les parasites couplés dans ce cas sur le signal audiophonique sont identiques sur tous les fils, puisque présentant la même impédance vis-à-vis de la source de ces perturbations.

Les signaux stéréophoniques peuvent donc être transmis de façon symétrique sur une liaison trifilaire puisque les deux canaux correspondants possèdent la même référence de potentiel.

Cependant, il convient de veiller à symétriser au maximum le schéma de la liaison pour rejeter efficacement les parasites de mode commun couplés sur la liaison ou résultant d'une différence de référence de masses.

Il va de soi bien entendu que d'autres modes de réalisation d'un tel dispositif peuvent être envisagés et que celui-ci peut être utilisé pour connecter toute source audiophonique à tout équipement de diffusion audiophonique embarqué à bord d'un véhicule automobile.

## Revendications

1. Dispositif de raccordement d'une source audiophonique (1) délivrant des signaux stéréophoniques, à un équipement de diffusion audiophonique (2) notamment d'un véhicule automobile, caractérisé en ce qu'il comporte :
- un étage d'entrée (3) comportant des moyens de mise en forme de signaux, recevant en entrée les signaux stéréophoniques (CDR,CDL) et la masse (CDGND) de la source audiophonique (1) et une tension de référence (Vref), pour délivrer des signaux de source référencés par rapport à la tension de référence,
- une liaison trifilaire torsadée (4) de transmission de ces signaux de source, et
- un étage de sortie (5) comportant des moyens d'adaptation d'impédance et d'amplification, pour récupérer les signaux stéréophoniques (CDR, CDL) sur la liaison trifilaire (4) et les délivrer à l'équipement de diffusion (2).

2. Dispositif selon la revendication 1, caractérisé en ce que les moyens de mise en forme comprennent un premier ensemble (6) de trois amplificateurs opérationnels (7,8,9) associés aux signaux stéréophoniques et à la masse de la source (1), dont la sortie de chacun est reliée à un fil respectif de la liaison trifilaire (4) à travers une résistance (10,11,12) et dont l'entrée inverseuse de chacun est reliée d'une part à sa sortie, à travers un condensateur (16,18,20) et d'autre part, au fil correspondant de la liaison trifilaire (17,19,21), et dont l'entrée non-inverseuse :
- d'un premier amplificateur (8) associé à la masse de la source (CDGND) est reliée à celle-ci et à la tension de référence (Vref), à travers une résistance (22),
- d'un second amplificateur (7) associé à l'un des signaux stéréophoniques (CDL) reçoit celui-ci à travers un condensateur de découplage (23) et est relié à la masse de la source et à la tension de référence (Vref), à travers une résistance (24), et
- d'un troisième amplificateur (9) associé à l'autre des signaux stéréophoniques (CDR) reçoit celui-ci à travers un condensateur de découplage (25) et est relié à la masse de la source et à la tension de référence (Vref), à travers une résistance (26).

3. Dispositif selon la revendication 1 ou 2, caractérisé en ce que les moyens d'adaptation d'impédance et d'amplification comprennent un étage de charge de trois résistances (31,32,33) raccordées en triangle respectivement entre les trois fils (13,14,15) de la liaison trifilaire (4).

4. Dispositif selon la revendication 3, caractérisé en ce que les moyens d'adaptation d'impédance et d'amplification comprennent un deuxième ensemble (34) de trois amplificateurs opérationnels (35,36,37) dont l'entrée inverseuse de chacun est reliée à sa sortie à travers une résistance (38,39,40) et dont l'entrée non-inverseuse de chacun est reliée à un fil respectif (13,14,15) de la liaison trifilaire (4) à travers une résistance (41,42,43).

5. Dispositif selon la revendication 4, caractérisé en ce que la sortie de l'amplificateur opérationnel (36) du deuxième ensemble d'amplificateurs (34) associé au fil de masse (14) de la liaison trifilaire (4) est reliée à travers des résistances (44,45) aux entrées non-inverseuses de deux amplificateurs opérationnels (46,47) d'un troisième ensemble (48) d'amplificateurs opérationnels, recevant chacun sur leur entrée inverseuse, la sortie de l'un des amplificateurs opérationnels (35,37) respectifs du second jeu d'amplificateurs opérationnels, associés aux fils de transmission des signaux stéréophoniques de la liaison (4) et dont la sortie est reliée à leur entrée inverseuse à travers une résistance (53,54) et délivre un signal stéréophonique correspondant (CDL, CDR) et en ce que les entrées non-inverseuses des amplificateurs opérationnels du troisième jeu sont raccordées à la tension de référence (Vref) respectivement à travers des résistances (49,50).
